# EUROPEAN PATENT APPLICATION

(11) **EP 3 059 759 A1**
(43) Date of publication of application: **24.08.2016**
(21) Application number: 16154991.0
(22) Date of filing: 10.02.2016
(51) Int. Cl.: H01L 23/31, H01L 25/065, H01L 25/10, H01L 21/60, H01L 21/98, H01L 25/03

(54) **INTEGRATED CIRCUIT PACKAGES WITH DUAL-SIDED STACKING STRUCTURE**

(30) Priority: 18.02.2015 US 201514625020
(71) Applicant: Altera Corporation, San Jose, CA 95134 (US)
(72) Inventor: LEE, Myung June, San Jose, CA 95134 (US)
(74) Representative: Hermann, Felix

(57) **Abstract**

An integrated circuit package may include a first integrated circuit die (101) attached to a front surface of a second integrated circuit die (102). An intermediate layer made of a molding compound (120) is formed to surround the second integrated circuit die in a "fan-out" arrangement while leaving a surface of the second integrated circuit die exposed. Accordingly, a group of via holes (210) is then formed in the intermediate layer and filled with a conductive material (106). Such a configuration forms a dual-sided stacking structure. The stacking structure may also be applicable for package-on-package packages and fan-out wafer-level chip scale packages, in which the stacking structure is formed between two heterogeneous or homogeneous integrated circuit packages.

## Description

### Background

In a semiconductor device assembly, an integrated circuit die (also referred to as a semiconductor chip or "die") may be mounted on a packaging substrate. With increasing need for higher performance and density, many integrated circuit packages have been incorporating more integrated components per unit area. Components may be placed closer or stacked together on printed circuit boards to lower device dimension and cost. For example, die-stacking (e.g., face-to-face die stacking, face-to-back die stacking) integration may be required for multi-die integrated circuit packages to obtain better performance and higher density.

Additionally, individual multi-die integrated circuit packages may also be stacked together to further improve the stability and manufacturability of the stacked package. Typical package-on-package stacking technologies may use packaging substrates with pre-mounted solder balls, or face-to-back or face-to-face package structures with solder balls that directly connect to their respective contact pads. However, such device packages requires higher processing cost to achieve finer pitch interconnections, due to the solder ball mounting process and material cost. To avoid a costly manufacturing process using typical stacking technologies, the solder balls need to be placed adequately far apart from each other (i.e., more than 300 micrometers apart), which undesirably limits the interconnection density of the integrated circuit package.

### Summary

In accordance with the present invention, apparatuses and methods are provided for creating integrated circuit packages with a dual-sided stacking structure.

It is appreciated that the present invention can be implemented in numerous ways, such as a process, an apparatus, a system, or a device. Several inventive embodiments of the present invention are described below.

An integrated circuit package produced by a process is disclosed. The process of producing an integrated circuit package may also include providing a first integrated circuit die and a second integrated circuit die, in which the first integrated circuit die is attached to a first surface of the second integrated circuit die. The process of producing the integrated circuit package may include forming an intermediate layer on the first integrated circuit die. The intermediate layer may be formed surrounding the second integrated circuit die. A group of conductive vias may be formed in the intermediate layer, where each of the conductive vias is connected to the first integrated circuit die. The group of conductive vias is formed by forming a group of holes in the intermediate layer. Each of the holes is filled with a conductive material after forming the group of via holes. A printing process or a squeeze-casting process may be performed to fill the group of via holes with the conductive material.

A method of fabricating an integrated circuit package is disclosed. The method includes attaching a first integrated circuit die to a front surface of a second integrated circuit die. An intermediate layer is then formed surrounding the second integrated circuit die. The method further includes forming an additional intermediate layer over the front surface of the second integrated circuit die and the additional intermediate layer. A group of conductive vias is subsequently formed in the intermediate layer. A plugging or printing process may be performed to fill the group of via holes with a conductive material. If desired, a third integrated circuit die is attached on the intermediate layer. The third integrated circuit die may be electrically coupled to the first integrated circuit die through the conductive vias in the intermediate layer. An additional group of conductive vias may be formed in the intermediate layer. The additional group of conductive vias may be filled with the conductive material through an additional plugging or printing process.

A method of manufacturing a package-on-package device is disclosed. The method includes mounting an integrated circuit die on a package substrate to form a first integrated circuit package. The integrated circuit die is encapsulated with a molding compound, in which a group of conductive vias is later formed in the molding compound. The method further includes forming an intermediate layer over the first integrated circuit die and the molding compound. Subsequently, a second integrated circuit package is mounted on the first integrated circuit package. The second integrated circuit die is electrically coupled to the first integrated circuit die through the group of conductive vias.

Further features of the invention, its nature and various advantages, will be more apparent from the accompanying drawings and the following detailed description of the preferred embodiments.

### Brief Description of the Drawings

FIG. 1 shows a side view of an illustrative integrated circuit package having two integrated circuit dies and a molding compound, in accordance with an embodiment of the present invention.
FIG. 2 shows an illustrative flow diagram of a manufacturing process for forming a dual-sided stacking structure of the type shown in FIG. 1, in accordance with one embodiment of the present invention.
FIG. 3 shows a side view of an illustrative package-on-package (PoP) package with stacked integrated circuit dies, in accordance with an embodiment of the present invention.
FIG. 4 shows a side view of another illustrative package-on-package (PoP) package with stacked integrated circuit dies, in accordance with an embodiment of the present invention.
FIG. 5 is a flow chart of illustrative steps that may be performed to assemble an integrated circuit package, in accordance with one embodiment of the present invention.
FIG. 6 is another flow chart of illustrative steps that may be performed to assemble an integrated circuit package, in accordance with one embodiment of the present invention.

### Detailed Description

The embodiments provided herein include integrated circuit structures and packaging techniques for creating integrated circuit packages with a dual-sided stacking structure.

It will be obvious, however, to one skilled in the art that the present exemplary embodiments may be practiced without some or all of these specific details described with reference to the respective embodiments. In other instances, well-known operations have not been described in detail in order not to obscure unnecessarily the present embodiments.

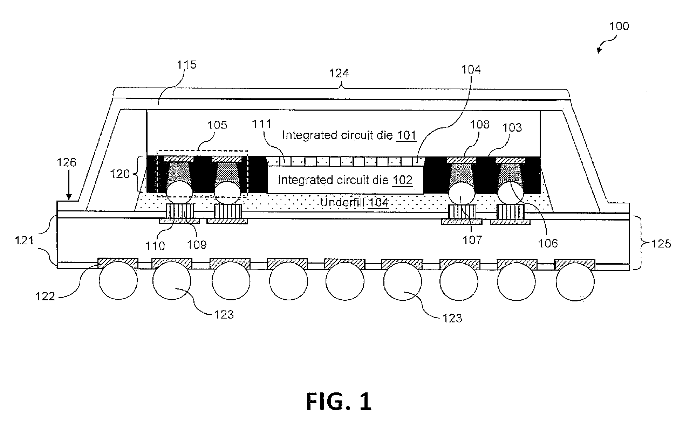

FIG. 1 shows a side view of integrated circuit package 100, in accordance with an embodiment of the present invention. As shown in FIG. 1, integrated circuit package 100 may include two integrated circuit dies (e.g., first and second integrated circuit dies 101 and 102) that are stacked with a face-to-face configuration for the purpose of increasing the packing density of integrated circuit package 100. For example, integrated circuit die 101 and integrated circuit die 102 are arranged with the respective front surfaces (e.g., active surfaces) of the integrated circuit dies facing each other. Support members 111 may be coupled between the integrated circuit dies 101 and 102 to electrically connect integrated circuit dies 101 and 102. For example, support members 111 may be copper pillars. Signals from integrated circuit die 101 may travel to integrated circuit die 102 via support members 111. It should also be appreciated that a variety of support members 111 having different configurations may be employed in this context. As an example, support members 111 may be microbumps. Underfill material 104 such as epoxy may be dispensed to fill the gap between integrated circuit die 101 and integrated circuit die 102, so as to improve bonding between integrated circuit die 101 and integrated circuit die 102.

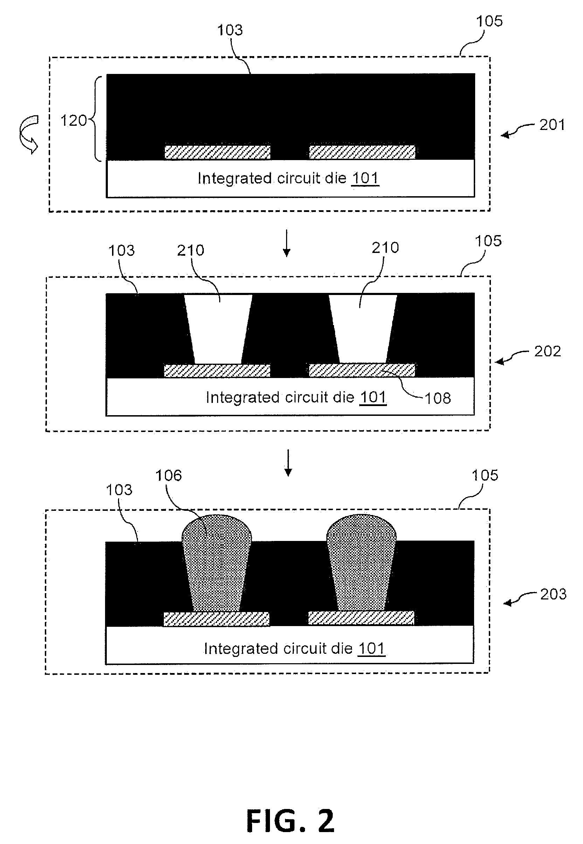

With the increasing demands for high density integrated circuit packages, a dual-sided stacking structure (e.g., stacking structure 120) may be desirable to accommodate fine-pitch scaling capability and resolve thermal management issues associated with an embedded integrated circuit die structure. The term "dual-sided" as used herein denotes that the top and bottom surfaces of the stacking structure are capable of connecting to one or more integrated circuit packages. In an exemplary embodiment, stacking structure 120 may include an intermediate layer (e.g., molding compound 103) having signal transmission structures (e.g., conductive vias 106). As an example, molding compound 103 may be formed surrounding integrated circuit die 102 prior to the formation of conductive vias 106. As shown in FIG. 1, conductive vias 106 may extend between the top surface and the bottom surface of molding compound 103 and connect to contact pads 108 on integrated circuit die 101 to form signal transmission structures. Such a stacking structure provides fine-pitch scaling capability in package-on-package stacking by eliminating the use of a packaging substrate with built-in pre-mounted solder balls, which require a coarser pitch. A more detailed description of stacking structure 120, highlighted by region 105, will be described later with reference to FIG. 2.

The stacked integrated circuit dies 101 and 102 may be coupled to package substrate 125 through microbumps 107. As shown in FIG. 1, each of microbumps 107 is bonded to a corresponding via of conductive vias 106 in molding compound 103. Such a configuration allows signals from integrated circuit die 101 to be conveyed to package substrate 125 through microbumps 107 and allows signals from substrate 126 to be conveyed to die 101 through microbumps 107. As shown in FIG. 1, package substrate 125 may include one or more conductive traces, such as conductive traces 110 for signal routing purposes. One or more layers of build-up film 121 (also referred to as a solder resist layer) may be applied over the top and/or the bottom surface of package substrate 125 to protect and insulate the conductive traces in package substrate 125 against oxidation.

A set of contact pads (e.g., contact pads 109) that are formed on the top surface of package substrate 125 may be coupled to molding compound 103 via microbumps 107. Accordingly, another set of contact pads (e.g., contact pads 122) that are formed on the bottom surface of package substrate 125 may be coupled to solder balls 123 to transmit signals out of integrated circuit package 100. The fabrication of contact pads 109 and 122 may be performed using any desired conventional manufacturing method, and therefore, is not described in detail in order to not unnecessarily obscure the present invention. Underfill 104 may be dispensed to fill the gaps between integrated circuit die 102, molding compound 103, and package substrate 125, so as to improve bonding between integrated circuit die 102, molding compound 103, and package substrate 125.

Subsequently, a heat conducting lid or heat spreading lid (e.g., heat spreading lid 115) may be attached to package substrate 125. As shown in FIG. 1, heat spreading lid 115 has a "hat-shaped" configuration. As an example, the "hat-shaped" heat spreading lid 115 has a flat surface (e.g., surface 124) which is raised from the sidewall of the package by an upstanding edge portion. Additionally, a lip (e.g., lip 126), which resembles the brim of a hat, may extend outwardly from the upstanding edge portion. It should be appreciated that heat spreading lid 115 may be formed from highly conductive material in order to effectively transfer heat generated by integrated circuit components such as integrated circuit die 101 out of integrated circuit package 100. Heat spreading lid 115 may substantially cover integrated circuit die 101 and a top surface of package substrate 125 to protect integrated circuit die 101 from external contaminants and damage.

FIG. 2 shows an illustrative flow diagram of a manufacturing process for forming the dual-sided stacking structure 120 of FIG. 1, as highlighted by region 105 of FIG. 1, in accordance with one embodiment of the present invention. As mentioned above, stacking structure 120 includes an intermediate layer (e.g., molding compound 103) having conductive vias 106.

In order to form stacking structure 120, the stacked integrated circuit dies 101 and 102 of FIG. 1 may be flipped or turned over such that the top surface (or the active surface) of integrated circuit die 101 faces upwards at step 201. In this way, molding compound 103 can be easily formed on integrated circuit die 101. Molding compound 103 may facilitate heat transfer, therefore allowing for better heat dissipation from integrated circuit die 102. Molding compound 103 may also protect integrated circuit dies 101 and 102 and their electrical connections (not shown) from breakage and hazardous environmental contaminants. The molding compound may be any suitable material, and in one embodiment may be composed of a mixture of epoxy resin and ceramic filler material.

At step 202, multiple openings (sometimes referred to herein as holes or via holes) are formed in molding compound 103. As shown in FIG. 2, via holes 210 may extend from the top surface to the bottom surface of molding compound 103 and to contact pads 108 on integrated circuit die 101 to form signal transmission structures. As an example, via holes 210 may be formed by drilling or lasering holes through molding compound 103. Subsequently, via holes 210 are filled with an electrically conductive metal to form conductive vias 106 at step 203. For example, conductive vias 106 may be formed through a printing process or a plugging process, in which the conductive metal (in the form of paste or powder) is deposited into via holes 210. Alternatively, conductive vias 106 may be formed by a casting process (e.g., a squeeze casting process), in which a molten conductive metal is squeezed into via holes 210 and then solidified. Examples of the conductive metal may include, among others, copper, tungsten, tin-lead, tin-copper, and tin-silver-copper.

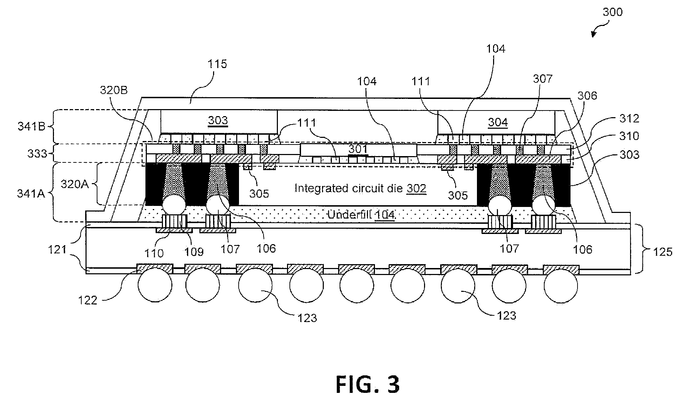

Dual-sided stacking structures may be implemented to accommodate various packaging device configurations. FIG. 3 shows a side view of an illustrative package-on-package (PoP) package 300 with stacked integrated circuit dies, in accordance with an embodiment of the present invention. It should be appreciated that PoP package 300 may share similar elements with integrated circuit package 100 of FIG. 1. As such, for the sake of brevity, structures and elements that have been described above, such as underfill 104, conductive vias 106, conductive traces 110, conductive pads 109 and 122, package substrate 125, build-up film 121, microbumps 107, solder balls 123, and heat spreading lid 115, will not be described in detail.

As shown in FIG. 3, PoP package 300 may include two integrated circuit packages (e.g, a first integrated circuit package 341A and a second integrated circuit package 341B) that are stacked together in a PoP arrangement. Each of the integrated circuit packages may include one or more integrated circuit dies made of heterogeneous technologies, which may be referred as heterogeneous integration. For example, the integrated circuit dies may include microprocessors, application specific integrated circuits (ASICs), memories, etc. In one embodiment, integrated circuit package 341A may include a die stack that implements two integrated circuit dies (e.g., integrated circuit dies 301 and 302) that are stacked face-to-face. Support members 111 may couple between integrated circuit dies 301 and 302 for electrical and signal communication. Accordingly, integrated circuit package 341B may include two integrated circuit dies (e.g., first and second integrated circuit dies 303 and 304), which are arranged adjacent to each other.

In order to form the PoP arrangement using integrated circuit packages 341A and 341B, two dual-sided stacking structures (e.g., stacking structures 320A and 320B) are provided. As shown in FIG. 3, stacking structure 320A includes an intermediate layer (e.g., molding compound 103) that is formed surrounding the sidewalls of integrated circuit die 301 in a "fan-out" (i.e., extending outwardly) arrangement. Accordingly, multiple via holes (e.g, conductive vias 106) are formed in molding compound 103 as signal transmission structures. Similar to stacking structure 320A, stacking structure 320B also includes an intermediate layer (e.g., intermediate layer 333) having signal transmission structures (e.g., conductive lines 306 and conductive vias 307). As shown in FIG. 3, intermediate layer 333 is formed over the surface of integrated circuit die 301 and molding compound 103 for structural support and physical isolation. Examples of intermediate layer 333 may include a passivation layer, a build-up layer, and a pre-impregnated layer.

In the embodiment of FIG. 3, intermediate layer 333 may include two layers; a lower layer (e.g., layer 310) and an upper layer (e.g., layer 312). In layer 310, multiple conductive lines (e.g., conductive lines 306) connecting the conductive vias 106 to the contact pads 305 on integrated circuit die 301 may fan outwardly. In layer 312, conductive vias 307 are formed for electrically connecting conductive lines 306 and support members 111. In one embodiment, conductive vias 307 relay signals from integrated circuit die 301 341A to integrated circuit dies 303 and 304 (and vice versa) through conductive lines 306. In an exemplary embodiment of FIG. 3, conductive vias 307 are formed by drilling or lasering one or more openings or via holes (e.g., via holes 210 of FIG. 2) to expose a portion of conductive lines 306. This is followed by a filling process of the openings with an electrically conductive metal (e.g., copper, tungsten, tin-lead, tin-copper, and tin-silver-copper) in the form of paste or powder to form conductive vias 307. Such a process may be carried out through a printing, plugging or squeeze-casting method. It should be appreciated that the location, shape, and size of conductive vias 307 are only for illustration purposes and are not limiting.

Subsequently, integrated circuit package 341B is stacked on top of integrated circuit package 341A via stacking structure 320B. As shown in FIG. 3, the signal transmission structures (e.g., conductive lines 306 and conductive vias 307) within stacking structure 320B allow integrated circuit dies 303 and 304 in integrated circuit package 341B to be electrically connected to integrated circuit die 302 of integrated circuit package 341A via support members 111.

To complete the assembly, the stacked integrated circuit packages (e.g., integrated circuit packages 341A and 341B) are mounted on package substrate 125. Accordingly, heat spreading lid 115 may be disposed over package substrate 125 and the stacked integrated circuit package structure to protect the stacked integrated circuit structure from external contaminants as well as to allow heat to escape from PoP package 300. Solder bumps or balls 123, disposed on the bottom surface of package substrate 125, may be used to connect PoP package 300 to external circuitry.

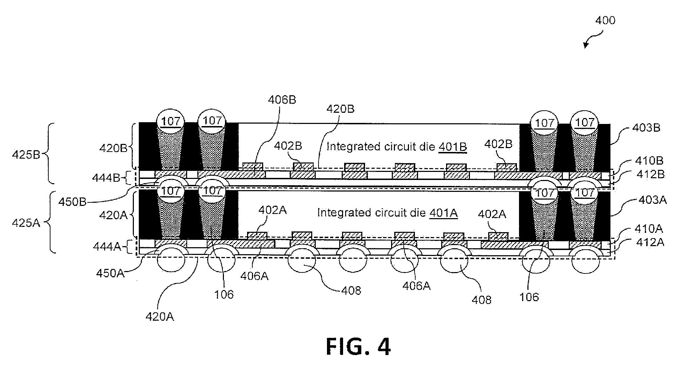

In some scenarios, homogeneous integrated circuit packages may be provided. FIG. 4 shows a side view of illustrative integrated circuit package device 400 with dual-sided stacking structures, in accordance with an embodiment of the present invention. It should be appreciated that integrated circuit package device 400 may share similar elements with integrated circuit package 100 and PoP package 300 of FIGS. 1 and 3. As such, for the sake of brevity, structures and elements that have been described above, such as molding compound 103, conductive vias 106, and microbumps 107, will not be described in detail. As shown in FIG. 4, integrated circuit package device 400 may include two homogeneous wafer level chip-scale packages (e.g., first package 425A and second package 425B). The term "homogeneous" may refer to packages with integrated circuit structures that are at least substantially similar in size, complexity, functionality, signal type, and so forth. For instance, package 425A may include integrated circuit die 401A whereas package 425B may include integrated circuit die 401B, where the integrated circuit die in both packages are homogeneous to one another.

Each of integrated circuit dies 401A and 401B may be surrounded by a molding compound (e.g., molding compound 403A, molding compound 403B, etc.). Similar to molding compound 103 of FIG. 3, molding compound 403A and 403B are "fan-out" (i.e., extending outwardly) molding compounds that are formed surrounding the respective integrated circuit dies (e.g., molding compound 403A is formed surrounding integrated circuit die 401A, molding compound 403B is formed surrounding integrated circuit die 401B). The "fan-out" arrangement of the molding compounds may protect integrated circuit dies 401A and 401B from external contaminants. This example is merely illustrative and, in general, any molding compounds 403 may be formed in any desired arrangement.

In one embodiment, a dual-sided stacking structure (e.g., stacking structure 420A, stacking structure 420B) is formed over the front surface (or the active surface) of each integrated circuit die and its respective molding compound. The dual-sided stacking structure may include an intermediate layer (e.g., intermediate layer 444A, intermediate layer 444B) having signal transmission structures. For example, in order to form stacking structure 420A, integrated circuit die 401A and molding compound 403A may be flipped or turned over such that the front surface (or the active surface) of integrated circuit die 401A faces upwards. This way, intermediate layer 444A may be easily formed over molding compound 403A and integrated circuit die 401A.

In one embodiment, intermediate layer 444A may include two layers; a lower layer (e.g., layer 410A) and an upper layer (e.g., layer 412A). For example, in layer 410A, multiple conductive lines (e.g., conductive lines 406A) in another "fan-out" arrangement may be formed and connected to conductive vias 106 of molding compound 403A and contact pads 402A of integrated circuit die 401A. Such an arrangement may extend the original connection points (e.g., contact pads 402A) of integrated circuit die 401A away from the footprint of integrated circuit die 401A, which allows integrated circuit die 401A to be connected to other electrical components within integrated circuit package device 400. In layer 412A, contact elements such as solder balls 408 are deposited on solder pads 450A and may electrically connected to conductive lines 406A to facilitate reliable signal transmission into and out of package 425A. In some embodiments, package 425A may, if desired, be inverted (or flipped over) such that intermediate layer 420A faces downwards towards a package substrate (not shown) onto which package 425A is mounted. For instance, the package substrate may be a printed circuit board substrate and package 425A may be connected to the printed circuit board via solder balls 408. The architecture of layers 410B and 412B of package 425B is the same as layers 410A and 412A of package 425A. Therefore, it should be appreciated that components shown in layers 410B and 412B (e.g., contact pads 402B, conductive lines 406B, and solder pads 450B) will not be described, for the sake of brevity.

In order to form integrated circuit package device 400, package 425B may be stacked on top of package 425A. Prior to the stacking of package 425B to package 425A, multiple conductive vias (e.g., conductive vias 106) are first formed in the molding compounds (e.g., molding compound 103) of each package using a method similar to that described above with reference to FIG. 2. Such a configuration forms stacking structure 441B, whose purposes are primarily to accommodate fine-pitch scaling capability. Accordingly, microbumps 107 are formed on conductive vias 106. As shown in FIG. 4, each of microbumps 107 is bonded to a corresponding via of conductive vias 106 of package 425A.

During the stacking of package 425B to package 425A, microbumps 107 are positioned adjacent to solder pads 450B of package 425B and a reflow process is performed to establish electrical and mechanical bonds between package 425A and package 425B. Signals from integrated circuit die 401A of package 425A may travel to integrated circuit die 401B of package 425B through microbumps 107. It should be appreciated that even though two chip-scale packages (e.g., package 425A and package 425B) are shown in the embodiment of FIG. 4, any number of chip-scale packages may be employed in this context.

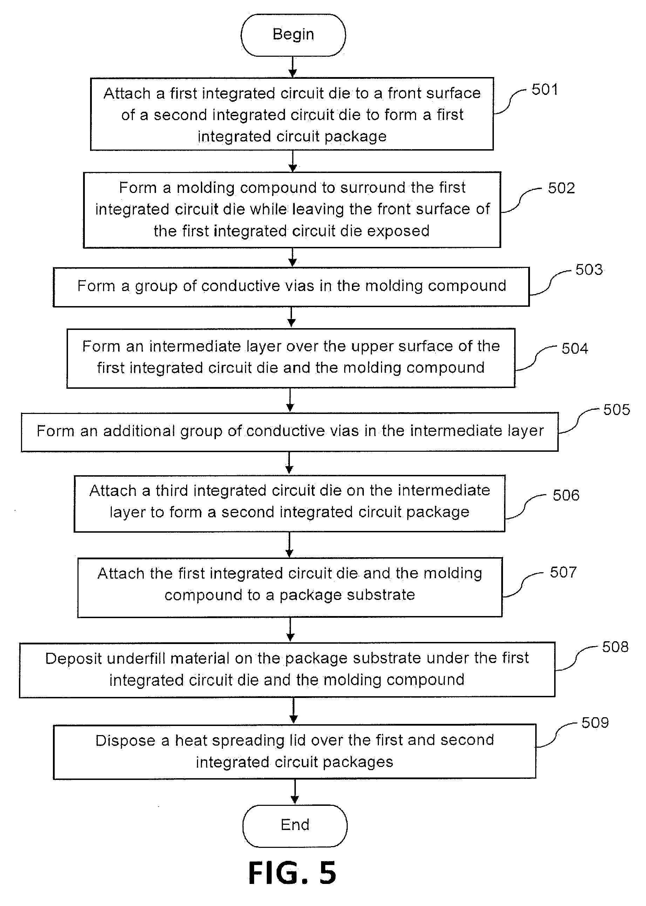

FIG. 5 is a flow chart of illustrative steps that may be performed by integrated circuit package assembly equipment to assemble an integrated circuit package, in accordance with one embodiment of the present invention. It should be appreciated that the embodiment of FIG. 3 may be used as an example to illustrate the steps described below. In one embodiment, the integrated circuit package may be an integrated circuit package-on-package (PoP) device (e.g., PoP package 300 of FIG. 3) in which two or more integrated circuit packages are stacked and integrally formed. For example, as shown in FIG. 3, PoP package 300 may include two integrated circuit packages (e.g., integrated circuit packages 341A and 341B) that are stacked together in the PoP arrangement.

In the first integrated circuit package (e.g., integrated circuit package 341A of FIG. 3), a first integrated circuit die is attached to a top surface of a second integrated circuit die at step 501. In an exemplary embodiment, a group of conductive pillars (e.g., support members 111 of FIG. 1) may be attached between the first integrated circuit die and the second integrated circuit die. For example, as shown in FIG. 3, the first integrated circuit die (e.g., integrated circuit die 301) is electrically coupled to the second integrated circuit die (e.g., integrated circuit die 302) through support members 111. In another example, support members 111 may include microbumps. In one embodiment, support members 111 may act as communication pathways between the integrated circuit dies. For example, signals from integrated circuit die 301 may be conveyed to integrated circuit die 302 via support members 111. Accordingly, an underfill material (e.g., underfill material 104) may be dispensed to fill the gap between integrated circuit die 301 and integrated circuit die 302.

At step 502, a molding compound is formed to surround the first integrated circuit die. For example, as shown in FIG. 3, molding compound 103 is formed to surround integrated circuit die 302 in a "fan-out" (i.e., extending outwardly) arrangement while leaving an upper surface of integrated circuit die 302 exposed. A molding process (e.g., an injection molding process) may be performed to enclose the sidewalls of integrated circuit die 302 within the molding compound.

At step 504, a group of conductive vias is then formed in the molding compound. In one embodiment, the molding compound and the group of conductive vias collectively form a first dual-sided stacking structure (e.g., stacking structure 320A of FIG. 3). For example, as shown in FIG. 3, conductive vias 106 extend between a top surface and a bottom surface of molding compound 103 to form signal transmission structures. Conductive vias 106 (or via holes) may be formed by drilling holes through molding compound 103. Each via hole may be subsequently filled with an electrically conductive metal (e.g., copper, tungsten, tin-lead, tin-copper, and tin-silver-copper). In one embodiment, conductive vias 106 are formed through a printing process, in which the conductive metal (in the form of paste or powder) is printed (or plugged) into via holes (e.g., via holes 210 of FIG. 2). In another embodiment, conductive vias 106 are formed by a squeeze casting process, in which a molten conductive metal is squeezed into the via holes and then solidified.

At step 504, an intermediate layer is formed over the upper surface of the first integrated circuit die and the molding compound. As shown in FIG. 3, intermediate layer 333 is formed on the top surface of integrated circuit die 301 and molding compound 103. In one embodiment, intermediate layer 333 includes two layers; a lower layer (e.g., layer 310) and an upper layer (e.g., layer 312). In layer 310, multiple conductive lines (e.g., conductive lines 306) may be formed and connected to conductive vias 106 of molding compound 103 and contact pads 305 of integrated circuit die 301.

At step 505, an additional group of conductive vias is formed in the intermediate layer. In one embodiment, the intermediate layer and the additional group of conductive vias collectively form a second dual-sided stacking structure (e.g., stacking structure 320B of FIG. 3). For example, as shown in FIG. 3, conductive vias 307 are formed in the upper layer (e.g., layer 312) of the intermediate layer. Conductive vias 307 may be formed by a similar fabrication process as conductive vias 106. In one embodiment, the stacking structure may act as a connecting bridge for connecting two or more integrated circuit packages in the PoP arrangement. Conductive vias 307 may act as connectors for signal transmission between the two integrated circuit packages.

In the second integrated circuit package (e.g., integrated circuit package 341B of FIG. 3), a third integrated circuit die is attached on the second stacking structure at step 506. Such an arrangement forms the PoP structure. As shown in FIG. 3, the third integrated circuit die (e.g., integrated circuit die 303) may be attached on top of intermediate layer 312 of stacking structure 320B. Support members 111 may couple between the integrated circuit die 303 and intermediate layer 320B for electrical communication. For example, support members 111 may be copper pillars. Signals from integrated circuit die 303 may travel to integrated circuit die 301 via support members 111 and 307, and conductive lines 306. If desired, additional integrated circuit dies may be attached on the intermediate layer. For example, as shown in FIG. 3, a fourth integrated circuit die (e.g., integrated circuit die 304) may be attached to intermediate layer 320B. Support members 111 may couple between integrated circuit die 304 and intermediate layer 320B for electrical connection.

At step 507, the first integrated circuit die and the molding compound are attached to a package substrate. In an example shown in FIG. 3, integrated circuit die 301 and molding compound 103 are mounted on package substrate 125 via microbumps 107. In one embodiment, each of microbumps 107 may connect to a corresponding via of conductive vias 106 in molding compound 103. A reflow process may be conducted so that molding compound 103 is mechanically and electrically connected to package substrate 125 by microbumps 107. As an example, microbumps 107 may be thermally reflowed at a reflow temperature of about 250°C.

At step 508, an underfill material is deposited on the package substrate under the first integrated circuit die and the molding compound. For example, as shown in FIG. 3, underfill 104 is dispensed to fill a gap between integrated circuit die 301, molding compound 103, and package substrate 125 so as to improve bonding between integrated circuit die 301, molding compound 103, and package substrate 125.

At step 509, a heat spreading lid is disposed over the first and second integrated circuit packages. The heat spreading lid may be made of highly conductive material in order to effectively transfer heat generated by integrated circuit components (e.g., integrated circuit dies 301, 302, 303, and 304 of FIG. 3) out of the PoP structure. For example, as shown in FIG. 3, the heat spreading lid (e.g., heat spreading lid 115) may substantially cover integrated circuit package 341A and integrated circuit package 341B and a top surface of package substrate 125 to protect integrated circuit dies 301, 302, 303, and 304 from external contaminants.

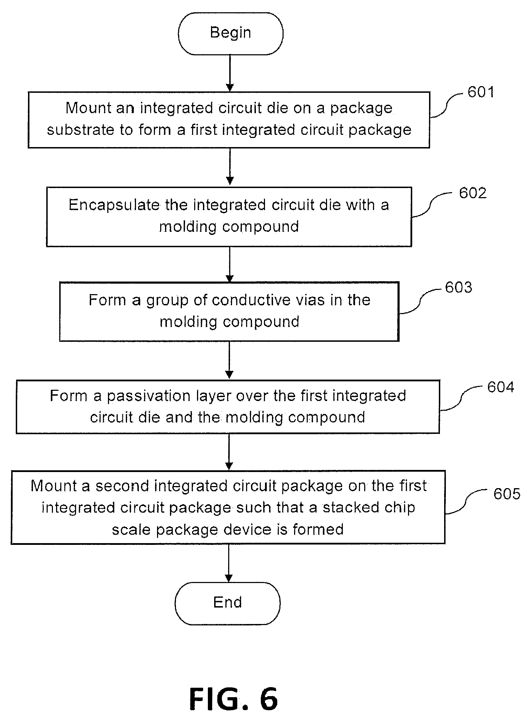

FIG. 6 is another flow chart of illustrative steps that may be performed by integrated circuit package assembly equipment to assemble an integrated circuit package, in accordance with an embodiment of the present invention. It should be appreciated that the embodiment of FIG. 4 may be used as an example to illustrate the steps described below.

At step 601, an integrated circuit die is mounted on a package substrate to form a first integrated circuit package. As shown in FIG. 4, the integrated circuit die (e.g., integrated circuit die 401A) may be mounted the package substrate (not shown) via solder balls 408. For instance, the package substrate may be a printed circuit board substrate.

At step 602, the integrated circuit die is encapsulated with a molding compound. As shown in FIG. 4, molding compound 103 may be deposited surrounding sidewalls of integrated circuit die 401A in a "fan-out" arrangement. The term "fan-out" may denote that molding compound 103 is formed by extending outwardly from the sidewalls of integrated circuit die 401A. In one embodiment, a group of conductive vias (e.g., conductive vias 106) is formed in molding compound 103 at step 603. Such a configuration forms stacking structure 425A, whose purposes, as mentioned above with reference to FIG. 3, may be primarily to accommodate fine-pitch scaling capability and resolve thermal management issues associated with integrated circuit die 401A.

At step 604, an intermediate layer is formed over the front surface (e.g., active surface) of first integrated circuit die and the molding compound. The intermediate layer, as shown in FIG. 4, may include two layers (e.g., layer 410A and 412A). In layer 410A, conductive lines 406A are formed and connected to conductive vias 106 and contact pads 402A of integrated circuit die 401A. In layer 412B, solder pads 410A are formed to electrically connect to conductive lines 406A. Accordingly, microbumps 107 may be soldered to conductive vias 106 on an opposing surface of molding compound 103.

At step 605, a second integrated circuit package may be stacked on the first integrated circuit package such that the package-on-package device is formed. The second integrated circuit package (e.g., package 425B) may be homogeneous to the first integrated circuit package (e.g., package 425B), which means package 425B have integrated circuit structures, including a stacking structure, that are at least substantially similar in size, complexity, functionality, signal type, and so forth to package 425A. During the stacking of package 425B to package 425A, microbumps 107 are reflow-soldered to form electrical and mechanical bonds between package 425A and package 425B. As such, signals from integrated circuit die 401B may travel to integrated circuit die 401A of package 425A through microbumps 107.

The method and apparatus described herein may be incorporated into any suitable circuit. For example, the method and apparatus may be incorporated into numerous types of devices such as microprocessors or other integrated circuits. Exemplary integrated circuits include programmable array logic (PAL), programmable logic arrays (PLAs), field programmable logic arrays (FPLAs), electrically programmable logic devices (EPLDs), electrically erasable programmable logic devices (EEPLDs), logic cell arrays (LCAs), field programmable gate arrays (FPGAs), application specific standard products (ASSPs), application specific integrated circuits (ASICs), and microprocessors, just to name a few.

Although the method operations were described in a specific order, it should be understood that other operations may be performed in between described operations, described operations may be adjusted so that they occur at slightly different times or described operations may be distributed in a system which allows the occurrence of the processing operations at various intervals associated with the processing, as long as the processing of the overlay operations are performed in a desired way.

### ADDITIONAL EMBODIMENTS:

Additional embodiment 1. An integrated circuit package produced by a process comprising: providing a first integrated circuit die; providing a second integrated circuit die having opposing first and second surfaces and attaching the first integrated circuit die to the first surface of the second integrated circuit die; forming an intermediate layer on the first integrated circuit die and surrounding the second integrated circuit die; forming a plurality of via holes in the intermediate layer; and filling the plurality of via holes with a conductive material after forming the plurality of via holes.

Additional embodiment 2. The integrated circuit package defined in additional embodiment 1, wherein the first surface of the second integrated circuit die comprises an active surface of the second integrated circuit die in which transistors are formed.

Additional embodiment 3. The integrated circuit package defined in additional embodiment 1, wherein the plurality of via holes is filled with the conductive material using a printing process.

Additional embodiment 4. The integrated circuit package defined in additional embodiment 1, wherein the plurality of via holes is filled with the conductive material using a squeeze casting process.

Additional embodiment 5. The integrated circuit package defined in additional embodiment 1, wherein the conductive material is selected from a group consisting of: copper, tungsten, tin-lead, tin-copper, and tin-silver-copper.

Additional embodiment 6. The integrated circuit package defined in additional embodiment 1, wherein the intermediate layer comprises a passivation layer.

Additional embodiment 7. The integrated circuit package defined in additional embodiment 1, wherein the intermediate layer comprises a molding layer.

Additional embodiment 8. The integrated circuit package defined in additional embodiment 1, wherein the process of producing the integrated circuit package further comprises: providing a package substrate and attaching the intermediate layer to the package substrate.

Additional embodiment 9. The integrated circuit package defined in additional embodiment 8, wherein the process of producing the integrated circuit package further comprises: depositing an underfill material on the package substrate under the intermediate layer and the second integrated circuit die.

Additional embodiment 10. The integrated circuit package defined in additional embodiment 9, wherein the process of producing the integrated circuit package further comprises: forming a heat spreading lid over the first integrated circuit die, the second integrated circuit die, and the package substrate.

Additional embodiment 11. A method of fabricating an integrated circuit package, the method comprising: attaching a first integrated circuit die to a front surface of a second integrated circuit die; forming an intermediate layer that surrounds the second integrated circuit die; forming an additional intermediate layer over the front surface of the second integrated circuit die and the intermediate layer; forming a plurality of via holes in the additional intermediate layer; and performing a plugging process to fill the plurality of via holes with a conductive material.

Additional embodiment 12. The method defined in additional embodiment 11, wherein attaching the first integrated circuit die to the front surface of the second integrated circuit die comprises electrically coupling the second integrated circuit die to the first integrated circuit die using a plurality of conductive interconnects.

Additional embodiment 13. The method defined in additional embodiment 11, wherein forming the intermediate layer comprises forming a molding compound that surrounds the second integrated circuit die.

Additional embodiment 14. The method defined in additional embodiment 13, wherein forming the intermediate layer that surrounds the second integrated circuit die comprises: forming an additional plurality of via holes in the intermediate layer; and performing an additional plugging process to fill the additional plurality of via holes in the intermediate layer with the conductive material.

Additional embodiment 15. The method defined in additional embodiment 14, further comprising: attaching the first integrated circuit die and the intermediate layer to a package substrate via solder bumps, wherein each of the solder bumps is bonded to a corresponding via hole of the additional plurality of via holes.

Additional embodiment 16. The method defined in additional embodiment 15, further comprising: attaching a third integrated circuit die on the additional intermediate layer, wherein the third integrated circuit die is electrically coupled to the first integrated circuit die through the plurality of via holes in the additional intermediate layer.

Additional embodiment 17. The method defined in additional embodiment 16, further comprising: depositing an underfill material on the package substrate under the first integrated circuit die and the intermediate layer.

Additional embodiment 18. The method defined in additional embodiment 17, further comprising: disposing a heat spreading lid over the first, second, and third integrated circuit dies and the package substrate.

Additional embodiment 19. A method of manufacturing a package-on-package device, the method comprising: mounting an integrated circuit die on a package substrate to form a first integrated circuit package; encapsulating the integrated circuit die with a molding compound; forming a plurality of openings in the molding compound, wherein each of the plurality of openings is filled with a conductive material through a squeeze casting process to form a plurality of conductive vias; forming a passivation layer over the integrated circuit die and the molding compound; and mounting a second integrated circuit package on the first integrated circuit package through the passivation layer.

Additional embodiment 20. The method defined in additional embodiment 19, wherein mounting the second integrated circuit package on the first integrated circuit package through the passivation layer comprises electrically coupling the second integrated circuit package to the first integrated circuit package via solder bumps, wherein each of the solder bumps is bonded to the conductive material in a corresponding opening of the plurality of openings.

Additional embodiment 21. The method defined in additional embodiment 19, wherein the second integrated circuit package comprises an additional integrated circuit die, and wherein mounting the second integrated circuit package on the first integrated circuit package comprises electrically coupling the additional integrated circuit die to the integrated circuit die through the plurality of openings.

The foregoing embodiments may be implemented individually or in any combination.

## Claims

1. An integrated circuit package produced by a process comprising:
a first integrated circuit die;
a second integrated circuit die having opposing first and second surfaces and attaching the first integrated circuit die to the first surface of the second integrated circuit die;
an intermediate layer formed on the first integrated circuit die and surrounding the second integrated circuit die;
a plurality of via holes formed in the intermediate layer; and
conductive material filling the plurality of via holes.

2. The integrated circuit package of claim 1, wherein the first surface of the second integrated circuit die comprises an active surface of the second integrated circuit die in which transistors are formed.

3. The integrated circuit package of claim 1 or 2, wherein the conductive material is copper, tungsten, tin-lead, tin-copper, or tin-silver-copper.

4. The integrated circuit package of one of claims 1 to 3, wherein the intermediate layer comprises a passivation layer.

5. The integrated circuit package of one of claims 1 to 4, wherein the intermediate layer comprises a molding layer.

6. The integrated circuit package of claim 1, further comprising:
a package substrate attached to the intermediate layer.

7. The integrated circuit package of claim 6, further comprising:
underfill material deposited on the package substrate under the intermediate layer and the second integrated circuit die; and
a heat spreading lid formed over the first integrated circuit die, the second integrated circuit die, and the package substrate.

8. A method of fabricating an integrated circuit package, the method comprising:
attaching a first integrated circuit die to a front surface of a second integrated circuit die;
forming an intermediate layer that surrounds the second integrated circuit die;
forming an additional intermediate layer over the front surface of the second integrated circuit die and the intermediate layer;
forming a plurality of via holes in the additional intermediate layer; and
performing a plugging process to fill the plurality of via holes with a conductive material.

9. The method of claim 8, wherein attaching the first integrated circuit die to the front surface of the second integrated circuit die comprises electrically coupling the second integrated circuit die to the first integrated circuit die using a plurality of conductive interconnects.

10. The method of claim 8 or 9, further comprising forming a molding compound that surrounds the second integrated circuit die.

11. The method of claim 10, further comprising:
forming an additional plurality of via holes in the intermediate layer; and
performing an additional plugging process to fill the additional plurality of via holes in the intermediate layer with the conductive material.

12. The method of one of claims 11, further comprising:
attaching the first integrated circuit die and the intermediate layer to a package substrate via solder bumps, wherein each of the solder bumps is bonded to a corresponding via hole of the additional plurality of via holes.

13. The method of one of claims 12, further comprising:
attaching a third integrated circuit die on the additional intermediate layer, wherein the third integrated circuit die is electrically coupled to the first integrated circuit die through the plurality of via holes in the additional intermediate layer.

14. The method of claim 13, further comprising:
depositing an underfill material on the package substrate under the first integrated circuit die and the intermediate layer; and
disposing a heat spreading lid over the first, second, and third integrated circuit dies and the package substrate.

15. The method of one of claims 8 to 14, wherein the plurality of via holes is filled with the conductive material using a printing process or using a squeeze casting process.
